# EUROPÄISCHE PATENTSCHRIFT

(11) **EP 0 852 556 B1**
(45) Veröffentlichungstag und Bekanntmachung des Hinweises auf die Patenterteilung: **03.04.2002**
(21) Anmeldenummer: 96945147.5
(22) Anmeldetag: 27.09.1996
(51) Int. Cl.: B65D 73/02, B65G 47/26

(54) **MAGAZIN FÜR DIE FIXIERUNG VON KLEINTEILEN**
MAGAZINE FOR FIXATION OF SMALL COMPONENTS
MAGASIN POUR LA FIXATION DE PETITS COMPOSANTS

(30) Priorität: 27.09.1995 DE 19535971
(43) Veröffentlichungstag der Anmeldung: 15.07.1998
(73) Patentinhaber: FRAUNHOFER-GESELLSCHAFT ZUR FÖRDERUNG DER ANGEWANDTEN FORSCHUNG E.V., 80636 München (DE); ACR Automation In Cleanroom Dresden GmbH, 01109 Dresden (DE); INSTITUT FÜR MIKROTECHNIK MAINZ GmbH, 55129 Mainz-Hechtsheim (DE); Karl Storz GmbH & Co. KG, 78532 Tuttlingen (DE)
(72) Erfinder: SCHMUTZ, Wolfgang, D-78658 Zimmern (DE); ERNST, Günter, D-01109 Dresden (DE); BERG, Udo, D-64297 Darmstadt (DE); KÄMPER, Klaus-Peter, D-55278 Mommenheim (DE); RENNER, Klaus, D-78576 Emmingen-Liptingen (DE); ROTHMAIER, Ulrich, D-78532 Tuttlingen (DE); RUDISCHHAUSER, Jürgen, D-78532 Tuttlingen (DE); GRIMME, Ralf, D-74385 Pleidelsheim (DE); SCHLENKER, Dirk, D-71701 Schwieberdingen (DE); STOCK, Achim, D-73433 Aalen (DE); SCHÄFER, Wolfgang, D-72622 Nürtingen (DE)
(74) Vertreter: Münich, Wilhelm, Dr.
(86) Internationale Anmeldenummer: DE9601850
(87) Internationale Veröffentlichungsnummer: WO9711888

(56) Entgegenhaltungen:
- EP-A- 0 392 331
- DE-A- 4 116 866
- FR-A- 1 236 131
- US-A- 3 472 365
- US-A- 3 871 936
- US-A- 3 968 873
- US-A- 4 099 611

## Beschreibung

### Technisches Gebiet

Die Erfindung betrifft ein Magazin für die Fixierung von Kleinteilen gemäß dem Oberbegriff des Patentanspruchs 1.

Derartige Magazine werden für die Fixierung bzw. das Magazinieren der verschiedensten Kleinteile, wie beispielsweise von kleinen Bauteilen aus der Mikrosystem- und Feinwerktechnik eingesetzt. Gattungsgemäße Magazine können dabei - gegebenenfalls in Verbindung mit zusätzlichen Kassetten oder Boxen - als Transport- oder Lagerbehälter oder als Zwischenspeicher während eines Fertigungsvorgangs in einem verketteten Produktionssystem dienen.

### Stand der Technik

Es ist bekannt, Kleinteile im ungeordneten Zustand zu transportieren und bereitzustellen. Dieser ungeordnete Zustand der Bauteile läßt eine genaue Positionierung dieser Teile für den Montage- und Fertigungsprozeß ohne zusätzlichen Aufwand für Vereinzelungen und Handhabungen nicht zu. Der Transport der Bauteile als Schüttgut kann außerdem zu einer Beschädigung der Teile führen; dies trifft besonders bei Bauteilen der Mikrosystemtechnik und der Feinwerktechnik zu.

Ferner ist es bekannt, einen Träger mit mehreren Taschen zu versehen, die mit einem Deckel abgedeckt werden, sogenannte Trays. Derartige Träger dienen in der Regel nur als Transportbehälter für die magazinierten Bauteile. Eine automatische Weiterverarbeitung der Bauteile in der Montage und Fertigung ist nur mit zusätzlichem Aufwand möglich, da die Abdeckungen nur schwer automatisiert zu entfernt sind, und darüberhinaus die Handhabung der Einzelteile beispielsweise mit einfachen Greifersystemen erschwert ist. Für die Handhabe und Entnahme der Bauteile bedarf es damit eines komplexen Greifersystems, das zum Beispiel mit'einer Bildverarbeitungseinrichtung zur Bestimmung der Orientierung und der Lage der Teile versehen sein muß. Ein wesentlicher Nachteil dieser Träger mit Taschen ist es außerdem, daß durch die Gestalt der Taschen die dort im Magazin befindlichen Bauteile nicht von allen Seiten zugänglich sind; für eine Bearbeitung der Kleinteile, eine Inspektion oder eine Reinigung ist es aber erforderlich, die Kleinteile von allen Seiten zugänglich zu halten. Eine Bearbeitung der Kleinteile in dem Träger mit Taschen ist in jedem Falle in der Praxis nicht möglich.

Weiterhin ist es bekannt, Kleinteile auf Foliengurten oder sogenanntem Gel-Paks mittels einer Klebeschicht zu fixieren. Die Gel-Paks beziehungsweise Foliengurte haben keine gegliederte Struktur und sind deshalb für die automatische Fertigungsbearbeitung nur begrenzt geeignet. Die Bereitstellung der Kleinteile, beispielsweise für die automatische Montage, muß auch hier mittels zusätzlicher Handhabungsschritte erfolgen. Dazu ist wiederum ein entsprechender Greifer erforderlich. Dieser Greifer muß mit einer zusätzlichen Bildverarbeitung versehen sein, da die Position der Kleinteile nur grob auf dem Foliengurt definiert ist und es sonst nicht zu einer definierten Aufnahme der kleinen Teile kommen kann. Auch hier sind Maßnahmen, die eine weitgehende Zugänglichkeit der Kleinteile von allen Seiten, beispielsweise bei der Fertigung erforderlich machen, nicht möglich, da zumindest eine Seite der Kleinteile auf der Klebefläche aufliegt und nicht frei zugänglich ist. Einen zusätzlichen Nachteil bilden die auf dem Kleinteil zurückbleibenden Kleberreste, der bei der zunehmenden Miniaturisierung der Bauteile an Bedeutung gewinnt und eine Anwendung derartiger Gel-Paks oder Foliengurte in der Mikrosystemtechnik praktisch nicht zuläßt.

Magazine für die Fixierung von Kleinteilen, von denen bei der Formulierung des Oberbegriffs des Patentanspruchs 1 ausgegangen worden ist, sind aus der EP 0 392 331 A1 oder der DE 41 16 866 A1 bekannt:

Aus der EP 0 392 331 A1 ist ein Magazin für Schmucksteine oder andere Kleinteile bekannt, das als Magazingrundträger einen Magazinstreifen aufweist, der aus einer Kunststofffolie besteht, die Vertiefungen zur Aufnahme der Schmucksteine aufweist. Die Vertiefungen sind zumindest einem Teilprofil der darin zu positionierenden Schmucksteine angepaßt und reihenförmig angeordnet.

Angrenzend an die Vertiefungen sind als Haltemittel Haltelippen vorgesehen. Diese Haltelippen greifen im geschlossenen Zustand über die positionierten Schmucksteine und fixieren dadurch ihre Lage. Hierzu sind die Haltelippen des aus der EP 0 392 331 A1 bekannten Magazins federnd vorgespannt und halten nach dem Eindrücken der Schmucksteine in die Vertiefungen diese in der fixierten Position. Es sind dabei mehrere parallele Reihen von Vertiefungen für die Aufnahme von Schmucksteinen möglich, so daß auch blatt- bzw. matrixförmige Ausführungsformen möglich sind, deren Länge und Breite etwa gleich groß sind.

Dementsprechend sind die Haltelippen durch elastische Verformung außer Eingriff mit den Schmucksteinen bringbar. Dazu sind die Haltelippen in Längs- oder Querrichtung des Magazinstreifens durchgehend angeordnet und weisen ein nach unten durchgehendes offenes Profil auf. Zur Entnahme der Schmucksteine werden die äußeren Haltelippen nach außen, d.h. von den Schmucksteinen weggebogen. Die Haltelippen kommen dadurch außer Eingriff mit den Steinen, so daß sich diese entnehmen lassen. Insbesondere können die Haltelippen durch Dehnen des Magazinstreifens quer zur Anordnungsrichtung der Haltelippen außer Eingriff mit den Schmucksteinen gebracht werden. Die Steine können dann mittels eines Tupfers oder Vakuumsaugers entnommen werden. Aufgrund der Dehnung ist es jedoch nur erschwert möglich, Kleinteile in beliebiger Reihenfolge, d.h. bei einer matrixförmigen Anordnung nacheinander aus unterschiedlichen Reihen und Spalten zu entnehmen.

Die Arbeitsschritte des Einführens des gefüllten Magazinstreifens in die Führungsschienen, das Bewegen des Magazinsstreifens längs der Führungsschienen und das darauf folgende Entnehmen aufgrund der geöffneten Haltelippen kann vollautomatisch erfolgen. Der Transport des Magazinstreifens kann beispielsweise durch eine auf der Unterseite angeordnete Walze erfolgen, wobei Mitnahmeeinrichtungen von unten hinter die Vertiefungen eingreifen und den Magazinstreifen vorwärts bewegen. Diese Magazinstreifen lassen sich auch für quaderförmige Elektronikbausteine verwenden.

Das aus der EP 0 392 331 A1 bekannte gattungsgemäße Magazin hat eine Reihe von Nachteilen: Die zu magazinierenden Kleinteile werden in Ausnehmungen eingesetzt, deren Innenkontur der Außenkontur der Kleinteile angepaßt ist.

Damit werden die Kleinteile zwar sicher kraft- und formschlüssig festgehalten, sie sind aber in dem Magazin nicht für einen Bearbeitungsvorgang zugänglich. Für eine Bearbeitung, aber auch für eine eine Inspektion und Reinigung der Kleinteile müssen diese aus den Vertiefungen des Magazins entnommen werden. Darüberhinaus ist das Magazin nur für eine Form und eine Größe der zu magazinierenden Kleinteile geeignet. Ein Einsatz des Magazins in einer Mischproduktion oder für den Versand unterschiedlicher Kleinteile ist damit nicht möglich.

Aus der DE 41 16 866 A1 ist ebenfalls ein gattungsgemäßes Magazin für die Fixierung von Kleinteilen, nämlich von Schmucksteinen bekannt, das als Magazingrundträger einen Magazinstreifen aufweist, in dem durchgehende Löcher vorgesehen sind, in die die Schmucksteine eingesetzt werden. Die Haltemittel werden dadurch gebildet, daß der Magazingrundträger eine Sandwich-Struktur aufweist, deren mittlere Schicht weich ist und in der Begrenzungswand eines jeden Lochs eine ringförmige Nut aufweist, in die die in Art eines Rhombus ausgebildeten Schmucksteine eingedrückt werden. Dieses Magazin erlaubt zwar eine Inspektion der magazinierten Kleinteil, es hat aber den Nachteil, daß es aufgrund der Gestaltung der fest in den Magazingrundträger eingebrachten Haltemittel nur die Magazinierung von Kleinteilen mit einer bestimmten Außenkontur und darüberhinaus mit fest vorgegebenem Durchmesser erlaubt. Die Magazinierung von optischen Mikrokomponenten, wie beispielsweise von Stablinsen, wie sie für Endoskope eingesetzt werden, ist mit einem derartigen Magazin nicht möglich. Auch die Bearbeitung der Kleinteile ist aufgrund der labilen Halterung nur begrenzt möglich. Vor allem aber ist es nicht an unterschiedliche Bauteilformen anpaßbar.

Aus der US 4,099,611 ist ein Magazin zur Fixierung von Kleinteilen insbesondere von sogenannten Steckohrringen bekannt. Dementsprechend sind die Haltemittel als Löcher in einer Platte ausgebildet, die lösbar in einem Grundrahmen befestigt ist. Durch die Löcher wird der Stecker der Ohrringe geschoben und von hinten mit dem Sicherungsteil des Ohrrings fixiert. Der Gegenstand dieser Schrift ist die lösbare Anbringung der Platte in dem Rahmen, so dass zur Veränderung der Dekoration die gesamte Platte leicht ausgetauscht werden kann. Eine Anordnung unterschiedlicher Elemente an unterschiedlichen Orten je nach späterem Einsatzzweck und eine bedarfsgerechte Entnahme ist mittels der in der US-Schrift vorgestellten Lösung nicht möglich. Insbesondere ist ein Bestücken und Entnehmen der Elemente auf bzw. von der Platte mit automatischen Vorrichtungen nicht möglich. Das Magazin ist immer nur für eine Form und Größe der zu magazinierenden Kleinteile geeignet.

### Darstellung der Erfindung

Der Erfindung liegt die Aufgabe zugrunde, ein Magazin für die Fixierung von Kleinteilen gemäß dem Oberbegriff des Patentanspruchs 1 derart weiterzubilden, daß mit minimalem Umrüstaufwand Kleinteile beliebiger Form und weitgehend beliebiger Größe -gegebenenfalls auch in einem Magazin gemischt - derart gespeichert werden können, daß jedes Kleinteil eine definierte örtliche Lage hat, so daß neben einer manuellen Bestückung und Entnahme auch eine automatisierte Bestückung und Entnahme in beliebiger Reihenfolge möglich ist.

Eine erfindungsgemäße Lösung dieser Aufgabe ist im Patentanspruch 1 angegeben. Weiterbildungen der Erfindung sind in den Ansprüchen 2 folgende angegeben.

Gemäß dem Oberbegriff des Patentanspruchs 1 weist zur Bildung der Haltemittel der Magazingrundträger Aufnahmen auf, die jeweils an definierten und bekannten Orten angeordnet sind und lösbar Fixierelemente halten, von denen jedes mit Befestigungsmitteln für das jeweils zu fixierende Kleinteil versehen ist.

Die Vorteile des erfindungsgemäßen Magazins bestehen darin, daß das Fixierelement für Kleinteile aus einem Grundrahmen besteht. Die Innenwand dieses Grundrahmens umfaßt teilweise einen Aufnahmeraum für die Kleinteile. Dieser Aufnahmeraum wiederum trägt Befestigungsmittel für die Kleinteile. Die Außenwand des Grundrahmens weist eine Funktionsfläche zur form- und/oder kraft- und/oder stoffschlüssigen Verbindung der Fixierelemente mit den Aufnahmeöffnungen des Magazingrundträgers auf. Der Grundrahmen des Fixierelementes kann zudem in seiner Höhe sehr flach gehalten werden.

Da die Aufnahmen für die Fixierelemente und damit auch die Fixierelemente an definierten und bekannten Orten angeordnet sind, kann das Beschicken, das Handhaben der Kleinteile im Magazin und die Entnahme der Kleinteile nicht nur manuell, sondern - bevorzugt - mit einer von einer insbesondere frei programmierbaren Steuereinheit gesteuerten Handhabungseinrichtung erfolgen. Die Handhabungseinrichtung kann beispielsweise geeignete Greifer, eine Reinigungseinrichtung, Oberflächenbearbeitungsmittel bzw. -werkzeuge etc. aufweisen. Dabei ist es bevorzugt, wenn die Aufnahmen auf dem Magazingrundträger regelmäßig und insbesondere in einer Form anqeordnet sind, die eine einfache Programmierung einer Steuereinheit für das Beschicken, Handhaben und/oder das Entnehmen der magazinierten Kleinteile erlaubt.

Insbesondere können die Aufnahmen in Form einer Matrix, die von quadratischen, rechteckigen oder trapezförmigen Elementen gebildet wird, oder in Form einer Wabe angeordnet sein, die von sechseckigen Elementen gebildet wird. Ferner sind Buch andere regelmäßige Anordnungen, wie lineare, konzentrische oder (halb)-kreisförmige Anordnungen möglich. Im Falle konzentrischer bzw. (halb)kreisförmiger Anordnungen kann zum Bewegen des Magazins ein einfacher Rundschalttisch benutzt werden.

Da die Fixierelemente lösbar von den Aufnahmen gehalten werden, können die Fixierelemente leicht ausgetauscht werden. Dieser Austausch kann beispielsweise zum Umrüsten der Magazine auf Kleinteile mit einer anderen Form dienen. Darüber hinaus ist es auch möglich, ein Kleinteil mit dem zugehörigen Fixierelement zu entnehmen.

In jedem Falle kann das erfindungsgemäße Magazin als Speicher bzw. Transporteinheit und/oder als Zwischenspeicher bei verketteten Fertigungen verwendet werden, wobei eine wahlfreie Beschickung und Entnahme ohne vorgegebene Reihenfolge möglich ist.

Bei einer bevorzugten Ausgestaltung weisen die Fixierelemente für jedes Kleinteil einen gesonderten Aufnahmeraum auf, so daß die Fixierelemente das Kleinteil bei der Handhabung auch schützen können.

Bei einer weiteren bevorzugten Ausgestaltung sind in dem Magazingrundträger ganz durchsetzende Aufnahmeöffnungen vorgesehen, die die Aufnahmen für die Fixierelemente zum Halten von Kleinteilen bilden. In diese Aufnahmeöffnungen werden die Fixierelemente für Kleinteile form- und/oder kraft- und/oder formschlüssig - z.B. durch Kleben oder Adhäsion - eingesetzt.

Dabei kann jeder Aufnahme ein Fixierelement oder mehrere Fixierelemente oder eine Gruppe von Fixierelementen zugeordnet sein.

Weiterhin ist es möglich, die Durchmesser der Aufnahmeöffnungen im Magazinträger und damit auch der Fixierelemente in mehrere unterschiedliche - eventuell normierte -Größenklassen einzuteilen.

Das erfindungsgemäße Magazin ist für eine Vielzahl von Anwendungen geeignet: Beispielsweise eignet es sich für die Magazinierung von Kleinteilen der Mikroelektronik, der Mikrosystemtechnik, der Feinwerktechnik und Optik. Weiterhin können auch Kleinteile und Präparate aus dem Bereich der Pharmazie, der Biologie, der Chemie etc. magaziniert werden, wobei von besonderem Vorteil ist, daß die Halte kraft durch Auswahl des Fixierelements dem jeweils zu speichernden Kleinteil angepaßt werden kann.

Als Beispiel für die universelle Anwendbarkeit des erfindungsgemäßen Magazins soll die Magazinierung von kleinen optischen Bauelementen genannt werden, wie Linsen, Stablinsen, Prismen etc. genannt werden, wie sie z.B. in Endoskopen eingesetzt werden.

Im Falle von Linsen ist es beispielsweise möglich, die im Magazin zu prüfen oder zu bearbeiten, beispielsweise mit Antireflex-Schichten zu versehen. Hierzu ist es bevorzugt, wenn eine Verschiebeeinheit vorgesehen ist, die die magazinierten Kleinteile bei Bearbeitungsvorgängen unterstützt und/oder für Prüf- und/oder Entnahmevorgänge axial verschiebt: Beispielsweise bei einer optischen Oberflächenprüfung kann damit die zu prüfende Fläche immer in den Fokus des Prüfgeräts verschoben werden.

Die bezüglich der Aufnahme axiale Verschiebeeinheit erlaubt darüber hinaus eine automatisierte Entnahme der Bauteile ohne zusätzliche Hilfsmittel.

In jedem Falle ist es von Vorteil, wenn die Verschiebeeinheit eine elektrisch, pneumatisch oder hydraulisch betätigte und von einer Steuereinheit gesteuerte Einheit ist.

Das erfindungsgemäße Magazin erlaubt natürlich die Speicherung bzw. Magazinierung beliebiger Teile, besonders bevorzugt ist jedoch seine Verwendung für Teile, deren Abmessungen etwa bis 10 mm Größe gehen; dies ist beispielsweise der maximale Durchmesser von Linsen bzw. Stablinsen in Endoskopen.

Weiterhin ist es möglich, den Durchmesser der Fixierelemente zu normieren. Für jeden dieser normierten Durchmesser bzw. Aufnahmeöffnungen lassen sich wiederum eine definierte Anzahl von Kleinteilen auf dem Magazingrundträger und ebenso wiederum in einem exakten Abstand der Kleinteile zueinander anordnen. Damit ist eine programmierbare Zuordnung der Kleinteile zu einer definierten örtlichen Lage und räumlichen Ausrichtung möglich. Eine automatisierte Fertigung und Bearbeitung ist deshalb ohne zusätzliche Maßnahmen möglich.

Eine automatisierte Handhabung wird weiter dadurch unterstützt, daß der Magazingrundträger Identifikationsmittel aufweist, die eine Identifikations des Magazins und/oder der darin fixierten Kleinteile erlaubt. Diese Identifikationsmittel können mechanische Codierungen, Barcodes, magnetische Codierungen und/oder Klarschrift-Codierungen umfassen.

Da die Größe der Durchmesser der Aufnahmeöffnungen in dem Magazingrundträger bzw. der Fixierelemente unabhängig ist von der Größe des Magazingrundträgers, läßt sich der Magazingrundträger bzw. dessen Rahmen jederzeit an gebräuchliche Standards in der Mikrosystemtechnik und Feinwerktechnik anpassen. So läßt sich der Rahmen mit dem Magazingrundträger beispielsweise in Handhabung- und Transportsysteme, wie zum Beispiel in die SMIF-Box (Standard Mechanical Interface) integrieren.

Das erfindungsgemäße Magazin für Kleinteile kann deshalb in bereits bestehende Fertigungsverfahren jederzeit integriert werden, indem eine entsprechende Anpassung der äußeren Abmessungen erfolgt.

Die Fixierelemente sind mit den Kleinteilen lösbar in jeder Aufnahmeöffnung angebracht, so daß jederzeit ein Austausch der Fixierelemente mit dem Kleinteil oder dem Kleinteil allein, zum Beispiel bei einem fehlerhaften Kleinteil, erfolgen kann.

In den Aufnahmeraum des Fixierelementes lassen sich nun je nach den Bedürfnissen des jeweiligen Anwendungsfalls stark differierende Mittel zur Befestigung dieser Kleinteile einbauen:

So können die Befestigungsmittel für die Kleinteile als Greiferfinger ausgebildet sein, wobei die Greiferfinger aus einem Greiferprofil mit einer Greiferfläche, einem Steg und einem Befestigungsteil an der Innenwand des Rundrahmens bestehen. Diese Befestigungsfinger lassen sich an ihrem Greiferprofil bauteilspezifisch ausbilden. Es ist so möglich, einen ganz geringen Teil der Oberfläche des zu fixierenden Kleinteils mit den Halteelementen zu belegen.

Aufgrund der flachen Bauweise des Fixierelementes bzw. des Grundrahmens und der spezifischen Ausbildung der Greiferfinger zum Halten von Kleinteilen ist es möglich, die Kleinteile in dem Magazingrundträger fast von allen Seiten zu inspizieren, zu reinigen und insbesondere sie einer automatischen Fertigungsbearbeitung zuzuführen. Die Kleinteile müssen damit bei der beidseitigen Bearbeitung in automatisierten Fertigungsstraßen weder aus dem Fixierelement noch aus dem Magazingrundträger entfernt werden.

Das erfindungsgemäße Magazin ist damit so gestaltet, daß es den Anforderungen aller Fertigungsschritte ohne Veränderung genügen kann und sich zusätzliche Handhabungsmaßnahmen während der automatischen Fertigung erübrigen. Die Kleinteile lassen sich also ohne Veränderungen in der fixierten Position in dem Fixierelement bzw. dem Magazingrundträger bei der Montage bearbeiten. Da die Befestigungsmittel überwiegend aus elastischem Material ausgeführt sind, kann sowohl das Einlegen in das Magazin wie auch das Entnehmen beispielsweise direkt durch ein Werkzeug für das Kleinteil während der Bearbeitung in der Fertigungsstraße automatisch durchgeführt werden.

Als Befestigungsmittel für Kleinteile in dem Aufnahmeraum des Fixierelementes lassen sich auch Schnappnasen an der Innenwand des Grundrahmens im Zusammenwirken mit Halteringen oder Haltevorsprüngen anbringen.

Weiterhin können als Befestigungsmittel auch eine entsprechende magnetische Kraft an der Innenwand des Grundrahmens des Fixierelementes dienen. Diese magnetische Kraft kann auch zusätzlich mit einem entsprechenden Haltering oder Haltevorsprung für die Kleinteile zusammenwirken.

Eine weitere Ausbildung der Befestigungsmittel für Kleinteile in dem Aufnahmeraum des Fixierelementes besteht aus einer Achse, die zur Aufnahme der Kleinteile dient, wobei die Achse in ihrer Spitze wenigsten eine und insbesondere zwei Schnappnasen zur Fixierung des Kleinteiles aufweist.

In weiterer Abwandlung der Erfindung kann der Grundrahmen geteilt sein, während die Befestigungsmittel als zwei halbkreisförmige Scheiben ausgeführt sein können, die dann in den Grundrahmen integriert sind. Diese beiden halbkreisförmigen Scheiben weisen einen Durchbruch zur Halterung eines Kleinteiles, wie beispielsweise eine Achse auf, die dort ebenfalls federnd gehalten wird. Die aufgeführten Ausführungsbeispiele für die unterschiedlichen Befestigungsmittel zeigen, daß höchst unterschiedlich geformte Kleinteile sich mittels des Magazingrundträgers in einer automatisierten Fertigung von der Herstellung über die Inspektion und das Reinigen verarbeiten lassen. Die Befestigung der Kleinteile in dem Fixierelement wie auch der Fixierelemente in dem Magazingrundträger ermöglicht die Entnahme der einzelnen Kleinteile in kürzester Zeit und mit einfachstem Arbeitsaufwand, obwohl die Kleinteile in dem Magazin so gehalten sind, daß eine Bearbeitung dieser Teile in dem Magazingrundträger erfolgen kann.

Ferner ist es möglich, daß der Grundrahmen des Fixierelements das Kleinteil nicht umschließt, und daß das Kleinteil den Magazingrundträger direkt berührt.

### Kurze Beschreibung der Zeichnung

Nachstehend wird die Erfindung anhand von Ausführungsbeispielen unter Bezugnahme auf die Zeichnung näher erläutert, in der zeigen:
- Fig. 1: ein erstes Ausführungsbeispiel eines erfindungsgemäß ausgebildeten Magazins zur Fixierung von Kleinteilen in Draufsicht
- Fig. 2a und b: Fixierelemente mit Befestigungsmittein, die als Greiferfinger ausgebildet sind,
- Fig. 3 und 4: die Greiferfinger vergrößtert im Detail,
- Fig. 5: die automatisierte Einführung eines Kleinteils in ein Fixierelement mit Greiferfingern,
- Fig. 6: ein weiteres Ausführungsbeispiel eines Fixierelements mit Befestigungsmitteln, die als Schnappnasen ausgebildet sind,
- Fig. 7 und 8: weitere Ausführungsbeispiele von Fixierelementen, die mit magnetischer Anziehungskraft als Haltekraft arbeiten,
- Fig. 9: ein weiteres Ausführungsbeispiel eines Fixierelements, das über eine Achse für Kleinteile als Befestigungsmittel verfügt, und
- Fig. 10 und 11: ein weiteres Ausführungsbeispiel eines Fixierelements und Befestigungsmittels, die geteilt ausgeführt sind.

### Beschreibung von Ausführungsbeispielen

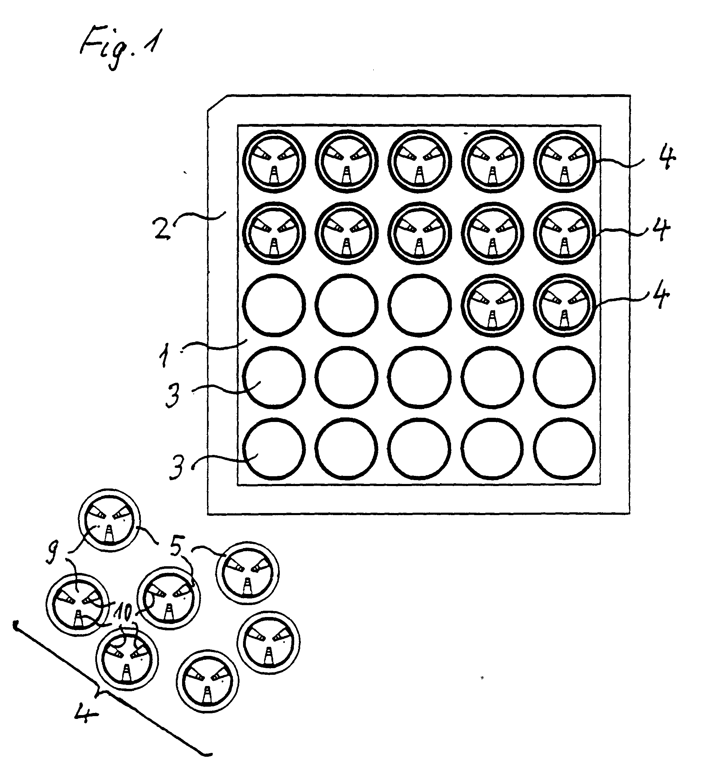

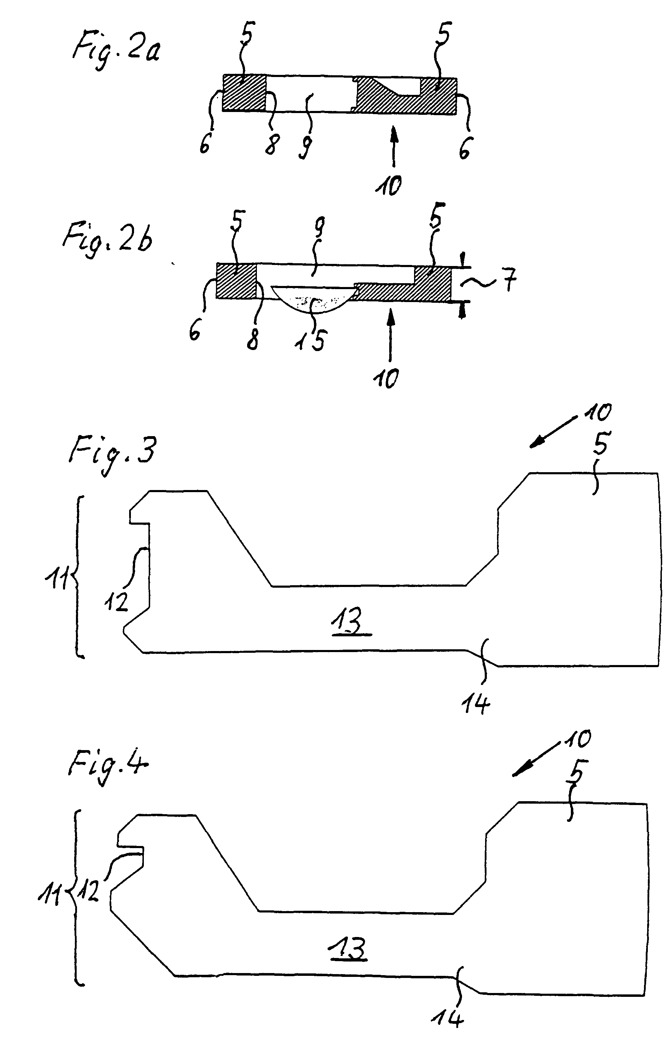

Fig. 1 zeigt in einer Draufsicht den grundsätzlichen Aufbau eines erfindungsgemäß ausgebildeten Magazins für die Fixierung von Kleinteilen. Bei den Kleinteilen kann es sich - wie bereits erläutert - um beliebige Teile, wie beispielsweise kleine Bauteile aus der Mikrosystemtechnik oder der Feinwerktechnik handeln. In den Fig. 2 bis 11 sind Details der Ausbildung eines erfindungsgemäß ausgebildeten Magazins dargestellt. Ausdrücklich wird darauf hingewiesen, daß ein Teil der Darstellungen in den Fig. 2 bis 11 aus Gründen der Übersichtlichkeit und der Deutlichkeit der Darstellung im Vergleich zu Fig. 1 und zu den tatsächlichen Abmessungen eines erfindungsgemäßen Magazins stark vergrößert dargestellt ist.

Das Magazin besteht aus einem Magazingrundträger 1, einem Rahmen 2 und Aufnahmen 3 für Fixierelemente 4. Bei dem gezeigten Ausführungsbeispiel sind die Aufnahmen als den Magazingrundträger 1 vollkommen durchsetzende Aufnahmeöffnungen 3 für die Fixierelemente 4 ausgebildet. Bei der Ausbildung der Aufnahmen als "durchgehende" Aufnahmeöffnungen handelt es sich um eine bevorzugte, jedoch nicht in jedem Falle erforderliche Ausgestaltung: So ist es auch möglich, die Aufnahmen in Art eines "Sackloches" oder als Vertiefung auszugestalten.

In den Aufnahmeöffnungen 3 lassen sich Kleinteile, die in den Fixierelementen 4 befestigt sind, in einer bestimmten, durch die Anordnung der Aufnahmeöffnungen 3 auf der Fläche des Magazingrundträgers 1 vorgegebenen geometrischen Anordnung magazinieren. Bei dem gezeigten Ausführungsbeispiel sind die Aufnahmeöffnungen 3 für die Fixierelemente 4 "matrixförmig" jeweils in den gedachten Schnittpunkten einer Rasteranordnung angeordnet, die aus aneinandergrenzenden und gleichen Quadraten gebildet wird. Selbstverständlich sind auch andere Anordnungen der Aufnahmeöffnungen 3 möglich: So ist es möglich, die "Matrix" aus Rechtecken oder eine "Wabe" aus Sechsecken aufzubauen. Die Abstände können dabei der Größe der zu magazinierenden Teile und/oder anderen den für eine automatische Fertigung sonstig erforderlichen Parametern angepaßt werden.

Die Anordnung der Aufnahmeöffnungen 3 in dem Magazingrundträger 1 sollte jedoch vorteilhafterweise so gewählt werden, daß sie in einfacher Weise in eine Steuereinheit eingegeben und insbesondere einprogrammiert werden kann, die die Bestückung des Magazins mit Kleinteilen und/oder die Entnahme der Kleinteile steuert. Hierzu kann beispielsweise wie folgt vorgegangen werden:

Da in einer Reihe beziehungsweise auf der Gesamtfläche des Magazingrundträgers 1 nur eine definierte Anzahl von Aufnahmeöffnungen 3 eingebracht werden kann, ergibt sich ein genau definierter Abstand der Kleinteile in den Fixierelementen 4 zueinander. Variiert wird der Abstand der Kleinteile in den Fixierelementen 4 beziehungsweise der Aufnahmeöffnungen 3 in dem Magazingrundträger 1 auch noch dadurch, daß die Durchmesser der Aufnahmeöffnungen 3 im Magazingrundträger 1 und analog dazu die Durchmesser der Fixierelemente 4 in mehrere unterschiedliche Größenklassen von Durchmessern von Aufnahmeöffnungen 3 beziehungsweise Fixierelementen 4 eingeteilt werden und damit eine Normierung der vorhandenen Durchmesser für Aufnahmeöffnungen 3 beziehungsweise Fixierelemente 4 vorgenommen wird.

Die zu magazinierenden Kleinteile liegen in der Elektronik, der Mikrosystemtechnik und der Feinwerktechnik etwa in der Größenordnung bis 10 mm. Dieser Bereich oder ein anderer für den jeweiligen Anwendungsfall zweckmäßiger Bereich wird nun in einige wenige Größen unterteilt, um jeweils einen optimalen Halt für die Kleinteile in den Fixierelementen 4 zu erreichen. In der Regel wird es zweckmäßig sein, je Magazingrundträger 1 nur eine Größenklasse von Durchmessern der Fixierelemente 4 beziehungsweise der Aufnahmeöffnungen 3 vorzusehen, für bestimmte Anwendungen können jedoch auch Aufnahmen 3 bzw. Aufnahmeöffnungen unterschiedlicher Größe bzw. Durchmesser in einem Grundträger 1 angebracht werden. In jedem Falle ergibt sich abhängig von den Außenmaßen des Rahmens für den Magazingrundträger 1 für die gewählte Normgröße an Aufnahmeöffnungen 3 bzw. Fixierelementen 4 wiederum der festgelegte Abstand der Kleinteile bzw. Fixierelemente 4 voneinander.

Da die Größe der Durchmesser der Aufnahmeöffnungen 3 bzw. der Fixierelemente 4 unabhängig von der Größe des Magazingrundträgers 1 ist, kann auch der Rahmen 2, der den Magazingrundträger 1 umgibt, in mehreren gleichen und ebenfalls standartisierten Größen ausgeführt werden. Die Größe des Rahmens 2 und damit des Magazingrundträgers 1 wird an die in bestehenden Transport- und Handhabungssystemen bereits verwendete Magazingrößen für die jeweiligen Bauteile, wie beispielsweise elektronische Bauteile angepaßt. So ist beispielsweise ein Handhabungs- und Transportsystem für Trays nach dem SMIF-Standard (Standard Mechanical Interface) bekannt, an dessen Geometrie die vorliegende Erfindung mit ihrem Magazinrahmen beziehungsweise Magazingrundträger angepaßt werden kann. Dies ist eine Voraussetzung dafür, daß in dem erfindungsgemäßen Magazin nicht nur Teile magaziniert und gehalten werden können, sondern daß das erfindungsgemäß ausgebildete Magazin auch in bereits bestehende Fertigungsanlagen jederzeit eingegliedert werden kann. Die Rahmengröße und damit die Außenkontur des Magazins ist also bevorzugt unabhängig von der Form und Größe der zu magazinierenden Kleinteile.

Die Gestaltung der Fixierelemente 4 des in Fig. 1 gezeigten ersten Ausführungsbeispiels wird im folgenden unter Bezugnahme auf die Detailzeichnung in Fig. 1 sowie die Fig. 2 bis 5 näher beschrieben:

Jedes Fixierelement 4 zur Halterung eines Kleinteiles besteht aus einem Grundrahmen 5 und Befestigungsmitteln, auf die im folgenden noch näher eingegangen wird. Jeder Grundrahmen 5 eines Fixierelementes 4 besitzt eine Außenwand 6, die als Funktionsfläche zur form-, kraft- und/oder stoffschlüssigen (beispielsweise durch Kleben) Verbindung der Fixierelemente 4 mit den Aufnahmeöffnungen 3 in dem Magazingrundträger 1 dient.

Zur Herstellung einer form- und/oder kraftschlüssigen Verbindung zwischen den Aufnahmeöffnungen 3 und dem Grundrahmen 5 kann dieser an seiner Außenwand 6 eine umlaufende Nut oder Sicke aufweisen, die federnd in einer Aufnahmeöffnung 3 einrastet, wobei diese Art der Verbindung zeichnerisch nicht dargestellt ist. Damit der Grundrahmen 5 federnd in eine Aufnahmeöffnung 3 einrasten kann und damit jedes Fixierelement 4 mit seinem Grundrahmen 5 jederzeit von dem Magazingrundträger 1 gelöst und somit beispielsweise ausgetauscht werden kann, wird das Material des Grundrahmens 5 aus einem federnden Werkstoff ausgeführt. Als Material für den Grundrahmen können Metall, Kunststoff oder magnetisches Material gewählt werden, die jeweils federnde Eigenschaften aufweisen.

Als Material'für den Magazingrundträger 1 kann ebenfalls Kunststoff, Metall oder ein magnetischer Werkstoff gewählt werden. Die Wahl der Werkstoffe sowohl für den Grundrahmen 5 wie auch für den Magazingrundträger 1 wird auf den jeweiligen Anwendungsfall des Magazins für Kleinteile abgestimmt. So wird man beispielsweise bei der Benutzung des Magazins zur Reinigung der dort magazinierten Kleinteile entsprechende Materialien für den Grundrahmen 5 und den Magazingrundträger 1 auswählen, die eine Korrosion dieser Teile bei Benetzung mit der Reinigungsflüssigkeit verhindern.

Der Grundrahmen 5 sowie die Aufnahmeöffnungen 3 in dem Magazingrundträger 1 und damit auch die Fixierelemente 4 können eine beliebige Form haben: beispielsweise können sie Kreisform, eine quadratische Form oder eine Rechteckform, eine trapezförmige oder eine sechseckige Form aufweisen. Es sind jedoch auch andere Formen der Aufnahmeöffnungen 3 und des Grundrahmens 5 des Fixierelementes 4 möglich, die der Form der zu magazinierenden und gegebenenfalls zu bearbeitenden Kleinteile in den Fixierelementen des Magazins angepaßt sind.

Die Grundrahmen 5 und damit auch die Fixierelemente 4 sind bevorzugt so ausgeführt, daß sie nur eine geringe Höhe 7 aufweisen. Dies gilt auch für die Dicke des Magazingrundträgers 1. Durch die geschilderte flache Bauweise des Grundrahmens 5 und des Magazinträgers 1 ist es möglich, besonders gut von fast allen Seiten an das magazinierte Kleinteil heranzukommen. Dies ist bezüglich der Inspektion, der Reinigung und Beschichtung und auch bezüglich der Fertigung und Bearbeitung von Kleinteilen wesentlich ist. Besonders vorteilhaft ist die flache Bauweise, wenn die aufgenommenen Kleinteile in dem Magazingrundträger 1 beziehungsweise den Fixierelementen 4 bearbeitet werden sollen.

Der Grundrahmen 5 jedes Fixierelementes 4 verfügt über eine Innenwand 8, die wenigstens teilweise einen Aufnahmeraum 9 für Kleinteile umschließt. In dem Aufnahmeraum 9 des Fixierelements 4 sind Befestigungsmittel für Kleinteile vorgesehen.

Bei dem ersten Ausführungsbeispiel für die Befestigungsmittel für Kleinteile in dem Aufnahmeraum 9 des Fixierelementes 4 sind diese als Greiferfinger 10 ausgebildet. Jeder Greiferfinger 10 besteht aus einem Greiferprofil 11 mit einer Greiferfläche 12, einem Steg 13 und einem Befestigungsteil 14 an der Innenwand 8 des Grundrahmens 5.

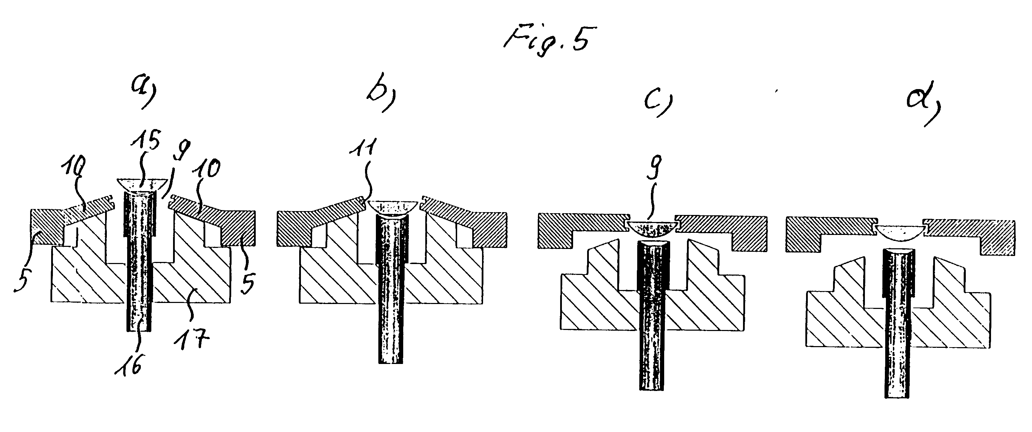

Bei den Greiferfingern 10 handelt es sich also um bauteilspezifische Befestigungsmittel. Sowohl das Greiferprofil 11 wie auch die Greiferfläche 10 werden, wie aus den Fig. 3 und 4 deutlich erkennbar ist, an die äußere Form der zu magazinierenden Kleinteile beziehungsweise an den zum Halten erforderlichen Kraftaufwand angepaßt; dabei sind die Kleinteile in den Fig. 2b und 5 lediglich schematisiert dargestellt. Es versteht sich von selbst, daß die Erfindung nicht auf die Magazinierung der dargestellten, vgl. einfachen Teile beschränkt ist.

Die Greiferfinger sowie auch die übrigen Befestigungsmittel der Fixierelemente 4 sind mit Ausnahme der magnetischen Werkstoffe aus federndem Material hergestellt, das nach einer elastischen Auslenkung in den Ausgangszustand zurückkehrt. Diese Aussage trifft auch für die im nachfolgenden Text noch geschilderten weiteren Ausführungsformen von Befestigungsmittein zu. Die Anzahl der Greiferfinger 10 in dem Aufnahmeraum 9 für Kleinteile, die an der Innenwand 8 des Grundrahmens 5 befestigt sind, wird begrenzt. Es können zwar - soweit der Platz reicht - 1 bis n derartige Greiferfinger 10 angeordnet werden, die Anzahl wird jedoch in der Regel so klein gehalten, daß die zu magazinierenden Kleinteile seitlich gut zugänglich bleiben. Die Zwischenräume zwischen den Greiferfingern 10 und den beiden Seiten des Magazins sollten insbesondere dann, wenn die Kleinteile in dem Magazin gereinigt oder beschichtet werden sollen - ein praktisch vollständiges Umströmen des zu reinigenden bzw. zu beschichtenden Kleinteiles mit dem Reinigungsfluid bzw. Beschichtungsmedium möglich machen. Darüberhinaus sollte eine gute Inspektionsmöglichkeit für die magazinierten Kleinteile erhalten bleibt.

Die erfindungsgemäß eingesetzten Greiferfinger 10 des Fixierelementes 4 ermöglichen eine definierte räumliche Fixierung und örtliche Lage der Kleinteile bei kleinstmöglicher Kontaktfläche der Greiferfinger 10 am Kleinteil. Die Greiferfinger 10 sind ebenfalls aus elastischem Material ausgeführt, sie können einstückig mit dem Grundrahmen 5 ausgeführt sein. Die elastischen Eigenschaften der Greiferfinger, die insbesondere auch durch den Steg 13 unterstützt werden, ermöglichen ein beliebig häufiges Bestücken und Entnehmen von Kleinteilen mit Hilfe fertigungspezifischer Entnahmevorrichtungen.

In den Figuren 2b und 5 ist, wie bereits erwähnt, ein stark vereinfachtes Kleinteil gezeigt. Wie insbesondere aus diesen Figuren ersichtlich ist, ermöglichen die elastischen Greiferfinger 10, in den Aufnahmeraum 9 Kleinteile einzubringen, zu entnehmen und zu bearbeiten.

Alle diese Vorgänge sind automatisiert in Fertigungsstraßen durchführbar, wie sie beispielsweise in der Elektronik-, der Feinwerktechnik- und/oder der Optikfertigung verwendet werden.

Durch das erfindungsgemäße Magazin beziehungsweise das Zusammenwirken der Fixierelemente mit Befestigungsmitteln mit dem Kleinteil wird es ermöglicht, nach der ursprünglich durchgeführten Lagerung des Kleinteiles in einer exakt definierten örtlichen Lage und in einer genauen Ausrichtung der Stellung des Kleinteiles, diesen ursprünglich hergestellten und geordneten Zustand des Kleinteiles auch in Fertigungsschritten, z.B. bei der Inspektion, bei der Reinigung und dergleichen beizubehalten, da die Bearbeitung für alle Fertigungsschritte der Kleinteile auch nach der Befestigung der Kleinteile im Magazin durchgeführt werden kann. Damit ist es nicht - wie bisher - erforderlich, die Kleinteile in ein für die weiteren Bearbeitungsschritte und -verfahren spezifisches Magazin umzuladen.

Dies soll unter Bezugnahme unter Fig. 5 erläutert werden:

In Fig. 5a ist gezeigt, wie mit einem Werkzeug 16, das hier nur teilweise dargestellt ist und beispielsweise als Sauggreifer ausgebildet sein kann, wobei jedoch auch jede andere Ausbildung eines Werkzeuges verwendet werden kann, das für das Kleinteil geeignet ist, ein Kleinteil 15 in die Fixiervorrichtung 4 eingefüllt wird. Dazu dient ein Hilfsmittel 17, das die elastischen Greiferfinger 10 angehoben hat, so daß eine vergrößerte Öffnung für die Aufnahme des Kleinteiles 15 entstanden ist. Nun wird durch das als Sauggreifer ausgebildete Werkzeug 16 das Kleinteil 15 ergriffen und durch Absenken des Sauggreifers das Kleinteil 15 in das Greiferprofil 11 der Greiferfinger 10 eingefügt. Gleichzeitig wird das Hilfsmittel 17 nach unten gefahren, so daß sich die elastischen Greiferfinger 10 wieder in den Ausgangszustand zurückstellen können, wie es aus den Fig. 5c und 5d ersichtlich ist.

Betrachtet man die Darstellung der Fig. 5 in umgekehrter Reihenfolge, das heißt von der Fig. 5 d fortschreitend zu Fig. 5c, 5b und 5a, so ergibt sich eine Darstellung für die Entnahme des Kleinteiles 15, die in umgekehrter Reihenfolge wie die Beschickung erfolgt.

Das Einfüllen und Entnehmen des Kleinteiles 15 kann selbstverständlich auch von der anderen Seite des Fixierelementes 5, also in der Darstellung von oben erfolgen. Der Aufbau des Fixierelementes 4 ermöglicht also die völlig freie Entnahme des Bauteiles aus dem Magazin mit einem entsprechenden Werkzeug, d.h es findet kein Abrieb des Kleinteiles oder des Fixierelements dabei statt. Das Bauteil kann darüber hinaus auch direkt auf einem auf der anderen Seite des Magazines liegenden nicht dargestellten Montagepunkt montiert werden, wie die Fig. 5a zeigt. Es ist jedoch auch möglich, das Kleinteil 15 ohne zusätzliche Handhabung und Verände-rung im Lauf der automatischen Fertigung zwischen den einzelnen Fertigungsschritten direkt zu bearbeiten.

Wie die Fig. 5d zeigt, kann die bei der ursprünglichen Magazinierung hergestellte vorliegende und geordnete Lage des Kleinteiles genutzt werden, um das Kleinteil während seiner Fixierung in dem Magazin zu bearbeiten bzw. eine Montage mit anderen Teilen durchzuführen. Dies ist möglich, da die Greiferfinger 10 elastisch sind und da es jederzeit möglich ist, das Kleinteil in der Lage 5 d von einer Seite mittels eines Stempels zu unterstützen und es von der anderen Seite zu bearbeiten. Dieses Bearbeitungsverfahren kann selbstverständlich in einem zweiten Schritt mit gewechseltem Stempel und Werkzeugen von der anderen Seite umgekehrt durchgeführt werden.

Der Aufbau der Fixierelemente 4 mit Greiferfingern 10 als Befestigungsmittel in dem Magazingrundträger 1 ermöglicht es auch jederzeit, defekte Kleinteile gleich nach ihrer Erkennung aus dem Fertigungsprozeß zu entfernen. Dies ist möglich durch Entfernen der defekten Kleinteile 15 aus dem Fixierelement 4 oder durch direkten Austausch des Fixierelementes 4 in dem Magazingrundträger 1, in dem das Fixierelement 4 lösbar befestigt ist.

Mit dem Magazin nach der Erfindung ist es auch möglich, ein defektes Fixierelement 4 einfach auszutauschen, ohne daß ein komplett neues Magazin entweder gekauft oder in den Fertigungsprozeß eingegliedert werden muß.

Durch die geschilderten Bearbeitungsmöglichkeiten, wie auch durch die bereits erwähnte Möglichkeit der Inspektion, Bearbeitung, Beschichtung und Reinigung der Kleinteile wird das erfindungsgemäße Magazin aufgrund seiner vielseitigen Anwendung in Fertigung und Montage zu einem Mittel, das Zeitersparnis und Verringerung des Handhabungsaufwandes für die Kleinteile bei der Fertigung und damit letztlich eine Kostenreduzierung in der Produktion von mikrosystemtechnischen und feinwerktechnischen Kleinteilen ermöglicht.

In dem ersten Ausführungsbeispiel von Befestigungsmitteln für die Fixierelemente 4, bei dem Greiferfinger 10 als Befestigungsmittel dienen, ist das in dem Fixierelement 4 gehaltene Kleinteil besonders gut zugänglich, d.h. es besteht eine größtmögliche Zugänglichkeit des Kleinteiles von beiden Seiten des Magazines, da die Fixierelemente 4 beziehungsweise der Grundrahmen 5 und auch die Befestigungsmittel in Form der Greiferfinger 10 sehr flach gehalten sind, so daß auch ein seitlicher Zugriff in spitzem Winkel in weitem Umfang möglich ist.

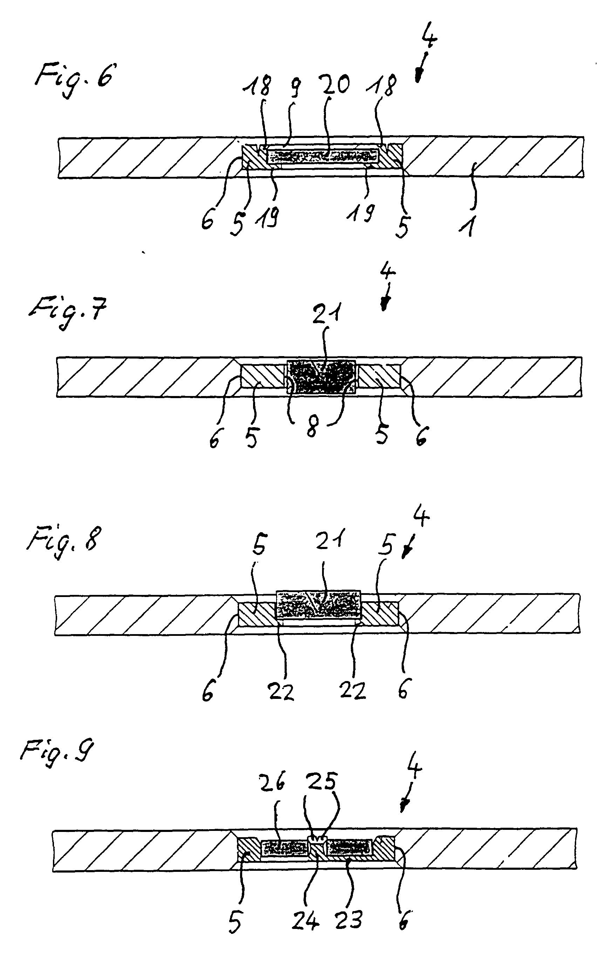

Eine zweite Ausführungsform der Befestigungsmittel ist in Fig. 6 dargestellt. Bei den Befestigungsmitteln, die in den Fig. 6, 7, 8, 9, 10 und 11 dargestellt sind, werden Kleinteile fixiert, bei denen die seitliche Zugänglichkeit in spitzem Winkel nicht in dem Ausmaß erforderlich ist, wie dies für Kleinteile gilt, die mit den Befestigungsmitteln in Form der Greiferfinger 10 gehalten werden.

Für alle hier beschriebenen Befestigungsmittel gilt, daß diese im wesentlichen durch die Gestalt und die Eigenschaften des zu fixierenden Kleinteiles beeinflußt werden, beispielsweise durch die Möglichkeit und die Form der Greiferflächen am Kleinteil, durch die Festigkeit des Kleinteiles und damit die Kraft mit der das Kleinteil gehalten werden kann bzw. die Kraft zum Halten, die erforderlich ist, um das Kleinteil im Magazin in den Fixierelementen 4 zu bearbeiten.

In Fig. 6 ist das Befestigungsmittel für Kleinteile in dem Aufnahmeraum 9 der Fixierelemente 4 als Schnappnasen 18 im Zusammenwirken mit einem an der Innenwand des Grundrahmens 5 umlaufenden Haltering 19 oder nicht dargestellten anstelle des Halteringes 19 stehenden Haltevorsprüngen ausgebildet. Der Haltering 19 beziehungsweise die nicht dargestellten Haltevorsprünge anstelle des Halteringes 19 dienen hier als definierte Auflagefläche für das Kleinteil 20. Der Haltering 19 kann damit als Unterlage des Kleinteiles 20 zur Montage und Bearbeitung dienen, wobei nochmals angemerkt wird, daß auch das Kleinteil 20 nur ein extrem vereinfachtes Kleinteil darstellt. Der Grundrahmen 5 und die mit ihm einstückig verbundenen Schnappnasen 18 bestehen aus federndem Werkstoff, so daß nach Eindrücken des Kleinteiles 20, bis es auf dem Haltering 19 aufliegt, das Kleinteil 20 von dem zurückfedernden Befestigungsmittel in Form der Schnappnasen 18 festgehalten wird. Die Außenwand 6 des Grundrahmens 5 ist wiederum als Funktionsfläche für das form- und/oder kraft- und/oder stoffschlüssige Verbinden des Fixierelementes 4 mit der Aufnahmeöffnung 3 in dem Magazingrundträger 1 ausgebildet.

In den Fig. 7 und 8 werden weitere Fixierelemente 4 gezeigt, die mit magnetischer Anziehungskraft als Befestigungsmittel arbeiten. Für geeignete Kleinteile 21, die einer magnetischen Beeinflussung zugänglich sind, ist ein Grundrahmen 5 vorgesehen, der aus magnetischem Material besteht. In dem Ausführungsbeispiel für Befestigungsmittel nach Fig. 7 wird die Fixierung des Kleinteiles 21 allein durch eine berührungslose Kraftübertragung zwischen dem magnetischen Grundrahmen 5 und dem Kleinteil 21 durchgeführt. Das Befestigungsmittel für Kleinteile in dem Aufnahmeraum 9 des Fixierelementes 4 ist in Gestalt einer die Kleinteile mit magnetischer Kraft haftenden Innenwand 8 des Grundrahmens 5 ausgeführt.

Bei einem weiteren Ausführungsbeispiel eines Befestigungsmittels mit Kleinteilen 21, die einer magnetischen Beeinflussung zugänglich sind, in Fig. 8 ist wiederum das Befestigungsmittel für Kleinteile in dem Aufnahmeraum 9 in Gestalt einer die Kleinteile mit magnetischer Kraft haltenden Innenwand 8 vorgesehen und zusätzlich ein Haltering 22 oder nicht dargestellte an der Stelle des Halteringes 22 liegende Haltevorsprünge zur Halterung des Kleinteiles 21 vorgesehen. Der Haltering 22 oder die an seiner Stelle liegenden Haltevorsprünge dienen wiederum dazu, eine definierte Auflagefläche des Kleinteiles zu erzeugen, wenn die Kräfte bei der Bearbeitung des Kleinteiles 21 größer sind als die Haltekräfte bei dem Ausführungsbeispiel für Befestigungsmittel nach der Fig. 7.

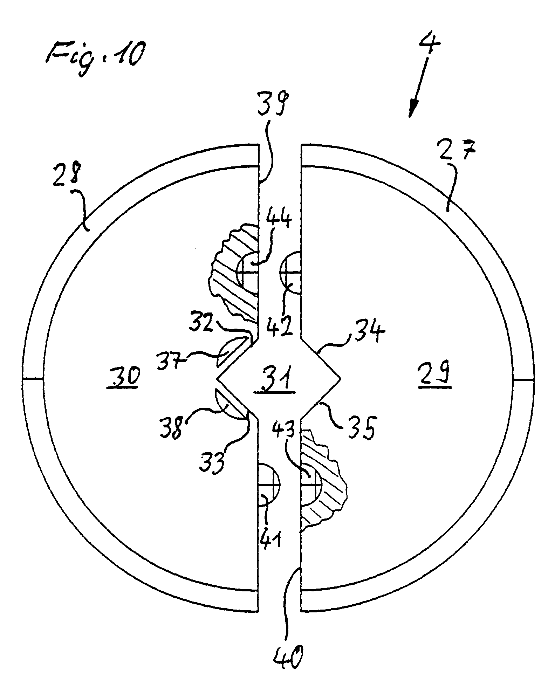

Ein weiteres Ausführungsbeispiel für Befestigungsmittel für Kleinteile in dem Aufnahmeraum 9 des Fixierelementes 4 zeigt die Fig. 9. Dort ist das Befestigungsmittel als eine mit wenigstens einem Arm 23 an der Innenwand 8 des Grundrahmens 5 befestigte Achse 24 zur Aufnahme des Kleinteiles ausgebildet. Die Achse 24 trägt an ihrer dem Arm 23 abgewandten Spitze wenigstens eine Schnappnase 25 zur Fixierung des Kleinteiles 26, wobei das Kleinteil eine Bohrung aufweist, in die die Achse 24 eingreifen kann. Ist das Kleinteil 26 bis auf Höhe des Armes 23 auf die Achse 24 gedrückt, so biegen sich die Schnappnasen 25 zurück und halten das Kleinteil 26 in dem Aufnahmeraum 9 des Fixierelementes 4. Auch hier wird die Außenwand 6 des Grundrahmens 5 des Fixierelementes 4 wiederum als Funktionsfläche für die form- und/oder kraft- und/oder stoffschlüssige Verbindung zwischen Fixierelement 4 und der Aufnahmeöffnung 3 in dem Magazingrundträger 1 benützt.

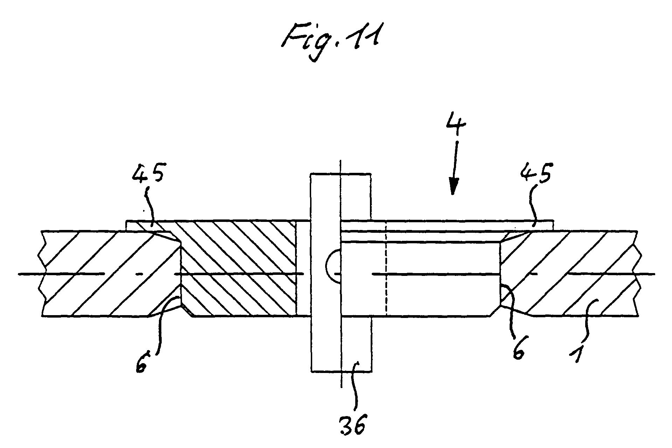

Ein weiteres Ausführungsbeispiel für ein Befestigungsmittel ist den Fig. 10 und 11 zu entnehmen. Hier ist der Grundrahmen 5 des Fixierelementes 4 geteilt ausgeführt, und zwar ist der Grundrahmen 5 in zwei Hälften 27 und 28 teilbar. Es sind Justiermittel für die beiden Rahmenhälften vorgesehen, die einen paßgenauen Sitz der beiden Hälften 27 und 28 des Grundrahmens ermöglichen, die jedoch nicht dargestellt sind. Als Befestigungsmittel für Kleinteile in dem'Aufnahmeraum 9 des Fixierelementes 4 sind bei dem Aus-führungsbeispiel nach den Fig. 10 und 11 die halbkreisförmigen Scheiben 29 und 30 ausgeführt, die in den Grundrahmen 5 beziehungsweise seine beiden Hälften 27 und 28 integriert sind. Die beiden halbkreisförmigen Scheiben 30 und 31 bilden je zur Hälfte die Form eines Durchbruches 31, der zur Halterung eines Kleinteiles 36 dient. Hinter wenigstens einem Teil der Seitenwände 32, 33, 34 und 35 des Durchbruches 31 sind Hohlräume 37 und 38 zur Erzielung einer federnden Klemmung des Kleinteiles 36 angeordnet. Da das Befestigungsmittel in Form der halbkreisförmigen Scheiben 29 und 30 beziehungsweise deren Wände 32, 33, 34 und 35 aus elastischem Material ausgeführt sind, wird das Kleinteil 36 durch die Wände des Durchbruches 31, der etwas kleiner ausgeführt ist als das Kleinteil, federnd in dem Durchbruch 31 gehalten. An den Berührungsseiten 39 und 40 der beiden halbkreisförmigen Scheiben 29 und 30 sind Noppen 41 und 42 beziehungsweise entsprechende Vertiefungen 43 und 44 für ein paßgenaues Zusammenführen der beiden halbkreisförmigen Scheiben 29 und 30 des Befestigungsmittels vorhanden.

Während in der Fig. 10 das Fixierelement 4 allein vergrößert dargestellt ist, zeigt Fig. 11 das Fixierelement mit dem Grundrahmen und den halbkreisförmigen Scheiben 29 und 30 des Befestigungsmittels in eingesetztem Zustand in den Magazinträger 1. Der Grundrahmen 5 in Gestalt seiner beiden Hälften besitzt wie bei allen vorhergehenden Ausführungsbeispielen des Grundrahmens als Befestigungsmittel Außenwände 6, die als Funktionsflächen zur form- und/oder kraftschlüssigen Verbindung des Fixierelementes 4 mit den Aufnahmeöffnungen 3 des Magazingrundträgers 1 dienen. In dem Ausführungsbeispiel des Befestigungsmittels nach Fig. 11 ist außerdem an der Außenwand 6 des Grundrahmens 5 ein umlaufender Steg zu entnehmen, der an dem Grundrahmen 5 beziehungsweise bei dem Ausführungsbeispiel der Fig. 10 und 11 den beiden Hälften 27 und 28 des Grundrahmens umgeformt ist. Der Durchmesser des Ringsteges 45 ist größer gewählt als der Durchmesser der Aufnahmeöffnung 3 zur Aufnahme des Fixierelementes 4 ausgeführt ist. Dieser Ringsteg 45 kann nicht nur bei dem Ausführungsbeispiel mit dem geteilten Grundrahmen nach Fig. 11 an den Fixierelementen 4 angebracht werden. Auch bei den anderen geschilderten Ausführungsbeispielen kann an dem Grundrahmen 5 ein Ringsteg 45 angeordnet werden. Dieser Ringsteg sorgt dafür, daß der Grundrahmen 5 und damit das Fixierelement 4 sich nicht in der Aufnahmeöffnung 3 des Magazingrundträgers 1 verschiebt. Dies ist für bestimmte Bearbeitungsvorgänge von Bedeutung.

Vorstehend ist die Erfindung anhand von Ausführungsbeispielen ohne Beschränkung des allegemeinen Anwendbarkeit und des allgemeinen Erfindungsgedankens beschrieben worden, innerhalb dessen die verschiedensten Abwandlungen möglich sind: So ist es möglich, daß die Achse und die Bohrung anstelle eines runden Querschnitts einen anderen Querschnitt, beispielsweise einen quadratischen oder einen sechseckigen Querschnitt haben.

### Bezugszeichenliste

- 1: Magazingrundträger
- 2: Rahmen
- 3: Aufnahmeöffnung
- 4: Fixierelement
- 5: Grundrahmen
- 6: Außenwand des Grundrahmens
- 7: Höhe des Grundrahmens
- 8: Innenwand des Grundrahmens
- 9: Aufnahmeraum für Kleinteile
- 10: Greiferfinger
- 11: Greiferprofil
- 12: Greiferfläche
- 13: Steg
- 14: Befestigungsteil
- 15: Kleinteil
- 16: Werkzeug
- 17: Hilfsmittel
- 18: Schnappnasen
- 19: Haltering
- 20: Kleinteil
- 21: Kleinteil
- 22: Haltering
- 23: Arm
- 24: Achse
- 25: Schnappnasen
- 26: Kleinteil
- 27: Hälfte des Grundrahmens
- 28: Hälfte des Grundrahmens
- 29: Halbkreisförmige Scheibe
- 30: Halbkreisförmige Scheibe
- 31: Durchbruch
- 32: Wand des Durchbruchs
- 33: Wand des Durchbruchs
- 34: Wand des Durchbruchs
- 35: Wand des Durchbruchs
- 36: Kleinteil
- 37: Hohlraum
- 38: Hohlraum
- 39: Berührungsseite
- 40: Berührungsseite
- 41: Noppe
- 42: Noppe
- 43: Vertiefung
- 44: Vertiefung
- 45: Ringsteg

## Patentansprüche

1. Magazin für die Fixierung von Kleinteilen, wie beispielsweise von kleinen Bauteilen aus der Mikrosystem- und Feinwerktechnik, mit einem Magazingrundträger, der Haltemittel für die Kleinteile aufweist, daß zur Bildung der Haltemittel der Magazingrundträger (1) Aufnahmen (3) aufweist, die jeweils an definierten und bekannten Orten angeordnet sind und lösbar Fixierelemente (4) halten, von denen jedes mit Befestigungsmitteln für das jeweils zu fixierende Kleinteil versehen ist, und daß die Fixierelemente (4) oder eine Gruppe von Fixierelementen mit Funktionselementen versehen sind, die eine form-, kraft- und /oder stoffschlüssige Verbindung mit der zugeordneten Aufnahme (3) herstellt,
**dadurch gekennzeichnet, daß** zur Bildung der Funktionselemente die Fixierelemente (4) einen Grundrahmen (5) aufweisen, dessen Innenwand (8) wenigstens teilweise einen Aufnahmeraum (9) für Kleinteile umfaßt, und dessen Außenwand (6) eine form- und/oder kraftschlüssige Verbindung der Fixierelemente (4) mit der jeweiligen Aufnahme (3) des Magazingrundträgers (1) herstellt.

2. Magazin nach Anspruch 1,
**dadurch gekennzeichnet, daß** in dem Aufnahmeraum (9) des Fixierelementes (4) Befestigungsmittel für die Kleinteile vorgesehen sind.

3. Magazin nach Anspruch 1 und 2,
**dadurch gekennzeichnet, daß** die Aufnahmen (3) auf dem Magazingrundträger (1) regelmäßig und insbesondere in einer Form angeordnet sind, die eine einfache Programmierung einer Steuereinheit für das Beschicken, Handhaben und/oder das Entnehmen der magazinierten Kleinteile erlaubt.

4. Magazin nach Anspruch 1 bis 3,
**dadurch gekennzeichnet, daß** die Fixierelemente (4) für jedes Kleinteil einen gesonderten Aufnahmeraum (9) aufweisen.

5. Magazin nach Anspruch 1 bis 4,
**dadurch gekennzeichnet, daß** die Aufnahmen Aufnahmeöffnungen (3) sind, in die die Fixierelemente (4) eingesetzt sind.

6. Magazin nach Anspruch 5,
**dadurch gekennzeichnet, daß** in jede Aufnahme (3) ein Fixierelement (4) eingesetzt ist.

7. Magazin nach Anspruch 5,
**dadurch gekennzeichnet, daß** in jede Aufnahme mehrere Fixierelemente oder eine Gruppe von Fixierelementen eingesetzt ist.

8. Magazin nach einem der Ansprüche 5 bis 7,
**dadurch gekennzeichnet, daß** die Aufnahmeöffnungen (3) den Magazingrundträger (1) vollständig durchsetzen.

9. Magazin nach Anspruch 1 bis 3,
**dadurch gekennzeichnet, daß** die Aufnahmen (3) in Form einer Matrix, die von quadratischen, rechteckigen oder trapezförmigen Elementen gebildet wird, in Form einer Wabe, die insbesondere von sechseckigen oder achteckigen Elementen gebildet wird, oder in einer linearen oder einer kreisförmigen Anordnung angeordnet sind.

10. Magazin nach einem der Ansprüche 1 bis 9,
**dadurch gekennzeichnet, daß** zur Herstellung einer form- und/oder kraftschlüssigen Verbindung zwischen den Fixierelementen (4) und den Aufnahmeöffnungen (3) der Grundträger (1) aus federndem Material ausgeführt ist.

11. Magazin nach Anspruch 1,
**dadurch gekennzeichnet, daß** zur Herstellung einer kraftschlüssigen Verbindung wenigstens die Funktionselemente der Fixierelemente aus magnetischem Material bestehen.

12. Magazin nach Anspruch 11,
**dadurch gekennzeichnet, daß** zur Herstellung einer form- und/oder kraftschlüssigen Verbindung zwischen den Fixierelementen (4) und den Aufnahmeöffnungen (3) der Grundrahmen (5) an seiner Außenwand (6) eine umlaufende Nut aufweist.

13. Magazin nach Anspruch 11 oder 12,
**dadurch gekennzeichnet, daß** der Grundrahmen (5) teilbar ausgeführt ist.

14. Magazin nach Anspruch 13,
**dadurch gekennzeichnet, daß** der Grundrahmen (5) in zwei Hälften (27, 28) geteilt ist, und daß Justiermittel für den paßgenauen Sitz der beiden Hälften vorgesehen sind.

15. Magazin nach Anspruch 11,
**dadurch gekennzeichnet, daß** an der Außenwand (6) des Grundrahmens (5) ein umlaufender Ringsteg (45) vorgesehen ist, dessen Durchmesser größer als der Durchmesser der Aufnahmeöffnungen (3) ist.

16. Magazin nach einem der Ansprüche 11 bis 15,
**dadurch gekennzeichnet, daß** der Grundrahmen (5) der Fixierelemente (4) eine geringe Höhe (7) aufweist.

17. Magazin nach Anspruch 1,
**dadurch gekennzeichnet, daß** die Befestigungsmittel aus federndem Material bestehen, das nach einer elastischen Auslenkung in den Ausgangszustand zurückkehrt.

18. Magazin nach Anspruch 1 oder 17,
**dadurch gekennzeichnet, daß** die Befestigungsmittel als Greiferfinger (10) ausgebildet sind.

19. Magazin nach Anspruch 18,
**dadurch gekennzeichnet, daß** die Greiferfinger (10) aus einem Greiferprofil (11) mit einer Greiferfläche (12), einem Steg (13) und einem Befestigungsteil (14) an der Innenwand (8) des Grundrahmens (5) bestehen.

20. Magazin nach Anspruch 19,
**dadurch gekennzeichnet, daß** das Greiferprofil (11) und die Greiferfläche (12) an die Form der zu fixierenden Kleinteile angepaßt sind.

21. Magazin nach Anspruch 1 oder 17,
**dadurch gekennzeichnet, daß** die Befestigungsmittel für Kleinteile in dem Aufnahmeraum (9) der Fixierelemente (4) als Schnappnasen (18) im Zusammenwirken mit einem an der Innenwand (8) des Grundrahmens (5) umlaufenden Haltering (19) oder Haltevorsprüngen ausgebildet sind.

22. Magazin nach Anspruch 1,
**dadurch gekennzeichnet, daß** die Befestigungsmittel dadurch gebildet sind, daß die Innenwand (8) des Grundrahmens (5) einen Magnet aufweist, der auf die Kleinteile eine Haltkraft ausübt.

23. Magazin nach Anspruch 22,
**dadurch gekennzeichnet, daß** die Innenwand (8) des Grundrahmens (5) zusätzlich mit einem Haltering (22) oder Haltevorsprüngen versehen ist.

24. Magazin nach Anspruch 1 oder 17,
**dadurch gekennzeichnet, daß** das Befestigungsmittel als eine mit wenigstens einem Arm (23) an der Innenwand (8) des Grundrahmens (5) befestigte Achse (24) ausgebildet ist, wobei die Achse (24) zur Aufnahme des Kleinteiles dient, und daß die Achse (24) an ihrer Spitze wenigstens eine Schnappnase (25) zur Fixierung des Kleinteiles aufweist.

25. Magazin nach Anspruch 1 oder 17,
**dadurch gekennzeichnet, daß** die Befestigungsmittel als halbkreisförmige Scheiben (29, 30) ausgeführt sind, die in dem Grundrahmen integriert sind,
daß die halbkreisförmigen Scheiben (29, 30) je die Hälfte der Form eines Durchbruches (31) zur Halterung eines Kleinteiles (36) aufweisen,
daß hinter wenigstens einem Teil der Seitenwände (32, 33, 34, 35) des Durchbruches (31) Hohlräume (37, 38) zur Erzielung einer federnden Klemmung der Kleinteile angeordnet sind, und
daß an den Berührungsseiten (39, 40) der halbkreisförmigen Scheiben (29, 30) Noppen (41, 42) beziehungsweise entsprechende Vertiefungen (43, 44) zum genauen Zusammenführen der beiden Scheiben (29, 30) vorhanden sind.

26. Magazin nach einem der Ansprüche 1 bis 24,
**dadurch gekennzeichnet, daß** der Magazingrundträger Identifikationsmittel aufweist, die eine Identifikation des Magazins und/oder der darin fixierten Kleinteile erlaubt.

27. Magazin nach Anspruch 26,
**dadurch gekennzeichnet, daß** die Identifikationsmittel mechanische Codierungen, Barcodes, magnetische Codierungen und/oder Klarschrift-Codierungen umfassen.

28. Magazin nach einem der Ansprüche 1 bis 27,
**dadurch gekennzeichnet, daß** ein Rahmen (2) den Magazingrundträger (1) umgibt.

29. Magazin nach Anspruch 28,
**dadurch gekennzeichnet, daß** der Rahmen (2) und damit der Magazingrundträger (1) eine standardisierte Größe aufweisen.

30. Magazin nach Anspruch 29,
**dadurch gekennzeichnet, daß** das Magazin in vorhandene Transport- und Handhabungssysteme einsetzbar ist.

31. Magazin nach Anspruch 30,
**dadurch gekennzeichnet, daß** das Magazin modular zu größeren Einheiten zusammengefaßt werden kann.

32. Magazin nach Anspruch 31,
**dadurch gekennzeichnet, daß** das Magazin in ein modulares Magazin- bzw. Kassetten-System, wie beispielsweise in die SMIF-Box eingesetzt werden kann.

33. Magazin nach einem der Ansprüche 1 bis 32,
**dadurch gekennzeichnet, daß** die Durchmesser der Aufnahmen (3) im Magazingrundträger (1) und analog dazu die Durchmesser der Fixierelemente (4) in mehrere unterschiedliche - gegebenenfalls normierte - Größenklassen von Durchmessern eingeteilt sind.

34. Magazin nach Anspruch 33,
**dadurch gekennzeichnet, daß** jeder Magazingrundträger (1) nur eine Größenklasse von Durchmessern der Aufnahmen (3) aufweist.

35. Magazin nach einem der Ansprüche 1 bis 34,
**dadurch gekennzeichnet, daß** der Magazingrundträger (1) aus Kunststoff oder Metall und/oder magnetischem Material besteht.

36. Magazin nach Anspruch 35,
**dadurch gekennzeichnet, daß** das Material eine Oberfläche bzw. Konsistenz hat, die eine leichte Reinigung und/oder einen Einsatz im Vakuum erlaubt.

37. Magazin nach einem der Ansprüche 1 bis 36,
**dadurch gekennzeichnet, daß** eine Verschiebeeinheit vorgesehen ist, die die magazinierten Kleinteile bei Bearbeitungsvorgängen unterstützt und/oder für Prüf- und/oder Entnahmevorgänge axial bezüglich der Aufnahme bzw. der Aufnahmebohrung verschiebt.

38. Magazin nach Anspruch 37,
**dadurch gekennzeichnet, daß** die Verschiebeeinheit eine elektrisch, pneumatisch oder hydraulisch betätigte und von einer Steuereinheit gesteuerte Einheit ist.

39. Magazin nach einem der Ansprüche 1 bis 38,
**dadurch gekennzeichnet, daß** der Grundrahmen (5) des Fixierelements (4) das Kleinteil nicht umschließt, und daß das Kleinteil (20) den Magazingrundträger direkt berührt.

## Claims

1. Magazine for the fixation of small parts such as small components used in micro system and precision mechanics, comprising a basic magazine support including means for holding said small parts, wherein said basic magazine support (1) comprises receptacles (3) for forming said holding means, which receptacles are disposed each at defined and known sites and hold fixing elements in a detachable form, and wherein said fixing elements (4) or a group of fixing elements are provided with functional elements co-operating with the respective associated receptacle (3) to establish a positive-locking connection, a non-positive locking connection and/or a connection by substance,
**characterised in that** said fixing elements (4) present a basic frame for forming said functional elements, whose inner wall (8) comprises, at least partly, a receiving space (9) for accommodating small parts and whose outer wall (6) presents a positive-locking connection and/or non-positive locking connection of said fixing elements (4) with the respective receptacle (3) of said basic magazine support (1).

2. Magazine according to Claim 1,
**characterised in that** means are provided in said receptacle (9) accommodating said fixing element (4) for fastening said small parts.

3. Magazine according to Claims 1 and 2,
**characterised in that** said receptacles (3) are disposed on said basic magazine support (1) in a regular arrangement and particularly in a shape that permits simple programming of a controller for feeding, handling and/or removal of said small parts stored in the magazine.

4. Magazine according to Claims 1 to 3,
**characterised in that** said fixing elements (4) present a separate receptacle (9) for each small part.

5. Magazine according to the Claims 1 to 4,
**characterised in that** said receptacles are receiving openings (3) into which said fixing elements (4) are inserted.

6. Magazine according to Claim 5,
**characterised in that** one fixing element (4) is inserted into each receptacle (3).

7. Magazine according to Claim 5,
**characterised in that** several fixing elements or a group of fixing elements are inserted into each receptacle.

8. Magazine according to any of the Claims 5 to 7,
**characterised in that** said receptacles (3)pass through said basic magazine support (1) completely.

9. Magazine according to the Claims 1 to 3,
**characterised in that** said receptacles (3) are disposed in the form of a matrix formed by square, rectangular or trapezoidal elements, in the form of a honey-comb formed by hexagonal or octagonal elements in particular, or in a linear or a circular arrangement.

10. Magazine according to the Claims 1 to 9
**characterised in that** said basic support (1) is made of a resilient material for the establishment of a positive-locking and/or non-positive locking connection between said fixing elements (4) and said receptacles (3).

11. Magazine according to Claim 1,
**characterised in that** at least said functional elements of said fixing elements are made of a magnetic material for establishing a non-positive locking connection.

12. Magazine according to Claim 11,
**characterised in that** said basic frame (5) presents a peripheral groove on its outer wall for establishing a positive-locking or non-positive locking connection between said fixing elements (4) and said receptacles (3).

13. Magazine according to Claim 11 or 12,
**characterised in that** said basic frame (5) is configured for being divided.

14. Magazine according to Claim 13,
**characterised in that** said basic frame (5) is divided into two halves (27, 28) and that adjusting means are provided for precise fitting of said two halves.

15. Magazine according to Claim 11,
**characterised in that** a peripheral annular web (45) is provided on said outer wall (6) of said basic frame (5), whose diameter is greater than the diameter of said receptacles (3).

16. Magazine according to the Claims 11 to 15,
**characterised in that** said basic frame (5) of said fixing elements (4) has a small height.

17. Magazine according to Claim 1,
**characterised in that** said fastening means consist of a resilient material that returns into the initial state after elastic deflection.

18. Magazine according to Claim 1 or 17,
**characterised in that** said fastening means are configured as gripping fingers (10).

19. Magazine according to Claim 18,
**characterised in that** said gripping fingers (10) consist of a gripping profile (11) with a gripping surface (12), a web (13) and a fastening element (14) on the inner wall (8) of said basic frame (5).

20. Magazine according to Claim 19,
**characterised in that** said gripping profile (11) and said gripping surface (12) are adapted to the shape of the small parts to be fixed.

21. Magazine according to Claim 1 or 17,
**characterised in that** said fastening means for small parts in said receptacle (9) of said fixing elements (4) are configured as snap-in projections (18) in co-operation with a holding ring (19) extending along the periphery of said inner wall (8) of said basic frame (5) or as holding projections.

22. Magazine according to Claim 1,
**characterised in that** said fastening means are formed by the provision that the inner wall (8) of said basic frame (5) presents a magnet exerting a holding force on said small parts.

23. Magazine according to Claim 22,
**characterised in that** said inner wall (8) of said basic frame (5) is additionally provided with a holding ring (22) or holding projections.

24. Magazine according to Claim 1 or 17,
**characterised in that** said fastening means is configured as an axle (24) mounted on the inner wall (8) of said basic frame (5) by at least one arm (23), which axle (24) serves to receive the small part, and that said axle presents at least one snap-in projection (25) on its tip for fixing said small part.

25. Magazine according to Claim 1 or 17,
**characterised in that** said fastening means are configured as semicircular disks (29, 30) integrated into said basic frame,
that said semicircular disks (29, 30) present each half of the shape of a breakthrough (31) for holding a small part (36),
that cavities (37, 38) are disposed behind at least one part of the side walls (32, 33, 34, 35) of the breakthrough (31) for achieving a resilient clamping action on said small parts, and
that knops (41, 42) or appropriate recesses (43, 44) are provided at the contacting sides (39, 40) of said semicircular disks (29, 30) for precisely approaching said two disks (29, 30).

26. Magazine according to the Claims 1 to 24,
**characterised in that** said basic magazine support comprises identification means permitting an identification of the magazine and/or the small parts fixed therein.

27. Magazine according to Claim 26,
**characterised in that** said identification means comprise mechanical codes, bar codes, magnetic codes and/or optically readable codes.

28. Magazine according to any of the Claims 1 to 27,
**characterised in that** a frame (2) surrounds said basic magazine support (1).

29. Magazine according to Claim 29,
**characterised in that** said frame (2) and hence said basic magazine support (1) present a standardised size.

30. Magazine according to Claim 29,
**characterised in that** the magazine is adapted for being inserted into existing shipping and handling systems.

31. Magazine according to Claim 30,
**characterised in that** the magazine is adapted for being combined in a modular manner to form major units.

32. Magazine according to Claim 31,
**characterised in that** the magazine is adapted for being inserted into a modular magazine or cartridge system such as a SMIF box.

33. Magazine according to any of the Claims 1 to 32,
**characterised in that** the diameters of said receptacles (3) in said basic magazine support (1), and by way of analogy the diameters of said fixing elements (4), are subdivided into several different - possibly standardised - diameter size classes.

34. Magazine according to Claim 33,
**characterised in that** each basic magazine support (1) comprises only one size class of diameters of said receptacles (3).

35. Magazine according to any of the Claims 1 to 34,
**characterised in that** said basic magazine support (1) consists of synthetic material or metal and/or magnetic material.

36. Magazine according to Claim 35,
**characterised in that** said material presents a surface or consistence, respectively, that permits easy cleaning and/or application in vacuum.

37. Magazine according to any of the Claims 1 to 36,
**characterised in that** a shifting unit is provided that supports the small parts contained in the magazine during processing operations and/or shifts them axially with respect to the receptacle or said receiving bore, respectively, for testing and/or removal operations.

38. Magazine according to Claim 39,
**characterised in that** said shifting unit is an electrically, pneumatically or hydraulically operated unit controlled by a controller unit.

39. Magazine according to any of the Claims 1 to 38,
**characterised in that** said basic frame (5) of said fixing element (4) does not enclose said small part, and that said small part (20) contacts said basic magazine support directly.

## Revendications

1. Magasin pour la fixation de petits composants comme des petits éléments utilisés dans des micro systèmes et dans la mécanique de précision, comprenant un support de base du magasin à tenir lesdits petits composants, dans lequel ledit support de base du magasin (1) comprend des empreintes de positionnement (3) à former desdits moyens de retenue, ces empreintes de positionnement étant disposées chacune aux lieus définis et connus et tenant des éléments de fixation de façon détachable, et dans lequel lesdits éléments de fixation (4) ou un groupe d'éléments de fixation sont munis des éléments fonctionnels en co-opération avec l'empreinte de positionnement (3) respective affectée afin d'établir une connexion mécanique, une connexion par adhérence et/ou une connexion par substance,
**caractérisé en ce que** lesdits éléments de fixation (4) présente un cadre de base à former lesdits éléments fonctionnels, dont la paroi intérieure (8) comprend, au moins en partie, un espace de logement (9) à recevoir des petits composants et dont la paroi extérieure (6) comprend une connexion mécanique et/ou une connexion par adhérence desdits éléments de fixation (4) avec l'empreinte de positionnement (3) respective dudit support de base du magasin (1).

2. Magasin selon la revendication 1,
**caractérisé en ce que** des moyens sont disposés dans ladite empreinte de positionnement (9) à recevoir ledit élément de fixation (4) afin d'attacher lesdits petits composants.

3. Magasin selon les revendications 1 et 2,
**caractérisé en ce que** lesdites empreintes de positionnement (3) sont disposés sur ledit support de base du magasin (1) en un arrangement régulier et en particulier sous une forme, qui permet la programmation simple d'une unité de réglage à alimenter, manipuler et/ou sortir lesdits petits composants emmagasinés dans le magasin.

4. Magasin selon les revendications 1 à 3,
**caractérisé en ce que** lesdits éléments de fixation (4) présentent une empreinte de positionnement (9) séparée pour chaque petit composant.

5. Magasin selon les revendications 1 à 4,
**caractérisé en ce que** lesdites empreintes de positionnement sont des ouvertures de logement (3), dans lesquelles lesdits éléments de fixation (4) sont insérés.

6. Magasin selon la revendication 5,
**caractérisé en ce qu'**un élément de fixation (4) est inséré dans chacune desdites empreintes de positionnement (3).

7. Magasin selon la revendication 5,
**caractérisé en ce que** plusieurs éléments de fixation ou un groupe d'éléments de fixation sont insérés dans chacune desdites empreintes de positionnement.

8. Magasin selon une quelconque des revendications 5 à 7,
**caractérisé en ce que** lesdites empreintes de positionnement (3) passent à travers ledit support de base du magasin (1) complètement.

9. Magasin selon les revendications 1 à 3,
**caractérisé en ce que** lesdites empreintes de positionnement (3) sont disposées sous forme d'une matrice formée par des éléments carrés, rectangulaires ou trapézoïdales, sous forme de nid d'abeille par des éléments hexagonaux ou octogonaux en particulier, ou en un arrangement linéaire ou circulaire.

10. Magasin selon les revendications 1 à 9
**caractérisé en ce que** ledit support de base (1) est fait en un matériau élastique à établir une connexion mécanique et/ou une connexion par adhérence entre lesdits éléments de fixation (4) et lesdites empreintes de positionnement (3).

11. Magasin selon la revendication 1,
**caractérisé en ce qu'**au moins lesdits éléments fonctionnels desdits éléments de fixation sont faits en un matériau magnétique à établir une connexion par adhérence.

12. Magasin selon la revendication 11,
**caractérisé en ce que** ledit cadre de base (5) présente une rainure périphérique sur sa paroi extérieure à établir une connexion mécanique ou connexion par adhérence entre lesdits éléments de fixation (4) et lesdites empreintes de positionnement (3).

13. Magasin selon la revendication 11 ou 12,
**caractérisé en ce que** ledit cadre de base (5) est configuré de façon à être divisé.

14. Magasin selon la revendication 13,
**caractérisé en ce que** ledit cadre de base (5) est divisé dans deux moitiés (27, 28) et **en ce que** des moyens d'ajustage sont disposés pour le logement précis desdites deux moitiés.

15. Magasin selon la revendication 11,
**caractérisé en ce qu'**une traverse annulaire périphérique (45) est disposée sur ladite paroi extérieure (6) dudit cadre de base (5), dont le diamètre est plus grand que le diamètre desdites empreintes de positionnement (3).

16. Magasin selon les revendications 11 à 15,
**caractérisé en ce que** ledit cadre de base (5) desdits éléments de fixation (4) a une petite hauteur.

17. Magasin selon la revendication 1,
**caractérisé en ce que** ledit moyen d'attache consiste en un matériau élastique, qui retourne en l'état initial suivant l'excursion élastique.

18. Magasin selon la revendication 1 ou 17,
**caractérisé en ce que** lesdits moyens d'attache sont configurés sous forme de doigts de prise (10).

19. Magasin selon la revendication 18,
**caractérisé en ce que** lesdits doigts de prise (10) consistent en un profil de prise (11) à une surface de prise (12), une traverse (13) et un élément de fixation (14) sur une paroi intérieure (8) dudit cadre de base (5).

20. Magasin selon la revendication 19,
**caractérisé en ce que** ledit profil de prise (11) et ladite surface de prise (12) sont adaptés à la forme des petits composants à fixer.

21. Magasin selon la revendication 1 ou 17,
**caractérisé en ce que** ledit moyen d'attache pour des petits composants dans ladite empreinte de positionnement (9) desdits éléments de fixation (4) sont configurés sous forme de saillies encliquetables (18) en coopération avec un anneau de retenue (19), qui s'étend le long de la périphérie de ladite paroi intérieure (8) dudit cadre de base (5) ou sous forme de saillies de retenue.

22. Magasin selon la revendication 1,
**caractérisé en ce que** lesdits moyens d'attache sont formés par la mesure, que la paroi intérieure (8) dudit cadre de base (5) présente un aimant, qui produit une force de retenue sur lesdits petits composants.

23. Magasin selon la revendication 22,
**caractérisé en ce que** ladite paroi intérieure (8) dudit cadre de base (5) est de plus muni d'une bague de retenue (22) ou des saillies de retenue.

24. Magasin selon la revendication 1 ou 17,
**caractérisé en ce que** ledit moyen d'attache est configuré sous forme d'un axe (24) monté sur ladite paroi intérieure (8) dudit cadre de base (5) par au moins un bras (23), cet axe (24) servant à recevoir le petit composant, et **en ce que** ledit axe présente au moins une saillie de serrage (25) à sa pointe à fixer ledit petit composant.

25. Magasin selon la revendication 1 ou 17,
**caractérisé en ce que** lesdits moyens d'attache sont configurés sous forme de disques demi-circulaires (29, 30) intégrés dans ledit cadre de base,
**en ce que** chacun desdits disques demi-circulaires (29, 30) présente la mi-forme d'un ajour (31) à tenir un petit composant (36),
**en ce que** des creux (37, 38) sont disposés derrière au moins une partie des parois latérales (32, 33, 34, 35) dudit ajour (31) à achever un effet de serrage élastique sur lesdits petits composants, et
**en ce que** des noppes (41, 42) ou des creusements (43, 44) sont formés aux côtés de contact (39, 40) desdites disques demi-circulaires (29, 30) à approcher, à précision, lesdits deux disques (29, 30).

26. Magasin selon les revendications 1 à 24,
**caractérisé en ce que** ledit support de base du magasin comprend des moyens d'identification, qui permettent l'identification du magasin et/ou des petits composants y fixés.

27. Magasin selon la revendication 26,
**caractérisé en ce que** lesdits moyens d'identification comprennent des codages mécaniques, des codes en caractères à bâtonnets, des codages magnétiques et/ou des codages en caractères optiquement lisibles.

28. Magasin selon une quelconque des revendications 1 à 27,
**caractérisé en ce qu'**un cadre (2) entoure ledit support de base du magasin (1).

29. Magasin selon la revendication 29,
**caractérisé en ce que** ledit cadre (2) et ainsi ledit support de base du magasin (1) présente une taille standardisée.

30. Magasin selon la revendication 29,
**caractérisé en ce que** le magasin est apte à être introduit dans des systèmes de transport et de maniement existant.

31. Magasin selon la revendication 30,
**caractérisé en ce que** le magasin est apte à être combiné, de façon modulaire, afin de former des unités majeures.

32. Magasin selon la revendication 31,
**caractérisé en ce que** le magasin est apte à être introduit dans un système de magasin ou de cassettes modulaires comme un box du type SMIF.

33. Magasin selon une quelconque des revendications 1 à 32,
**caractérisé en ce que** les diamètres desdites empreintes de logement (3) dans ledit support de base du magasin (1), et de manière analogique, les diamètres desdites éléments de fixation (4), sont divisés dans plusieurs classes de taille de diamètre différentes - éventuellement standardisées.

34. Magasin selon la revendication 33,
**caractérisé en ce que** chaque support de base du magasin (1) ne comprend qu'une seule classe de diamètres desdites empreintes de logement (3).

35. Magasin selon une quelconque des revendications 1 à 34,
**caractérisé en ce que** ledit support de base du magasin (1) est fait en un matériau synthétique ou en métal et/ou en un matériau magnétique.

36. Magasin selon la revendication 35,
**caractérisé en ce que** ledit matériau a une surface ou respectivement une consistance, qui permet le nettoyage facile et/ou l'emploi sous vide.

37. Magasin selon une quelconque des revendications 1 à 36,
**caractérisé en ce qu'**une unité de déplacement est disposée, qui appuie lesdits petits composants reçus dans le magasin au cours des opérations de traitement et/ou les déplace en sens axial, relatif à l'empreinte de positionnement ou respectivement à ladite ouverture de logement pour des opérations d'essai et/ou d'enlevage.

38. Magasin selon la revendication 39,
**caractérisé en ce que** ladite unité de déplacement est une unité à actionnement électrique, pneumatique ou hydraulique, commandée par une unité de commande.

39. Magasin selon une quelconque des revendications 1 à 38,
**caractérisé en ce que** ledit cadre de base (5) dudit élément de fixation (4) n'entoure pas ledit petit composant, et **en ce que** ledit petit composant (20) se trouve en contact direct avec ledit support de base du magasin.
